# EUROPÄISCHE PATENTSCHRIFT

(11) **EP 0 856 594 B1**
(45) Veröffentlichungstag und Bekanntmachung des Hinweises auf die Patenterteilung: **13.06.2001**
(21) Anmeldenummer: 97123034.7
(22) Anmeldetag: 31.12.1997
(51) Int. Cl.: C23C 16/02, C23C 14/02, C23C 16/56, C23C 14/58, C23C 16/44, C23C 14/22

(54) **Vorrichtung zur Plasma-Oberflächenbehandlung von Werkstücken**
Apparatus for plasma treatment of substrates
Appareil de traitement de substrats par plasma

(30) Priorität: 07.01.1997 DE 29700113 U; 22.07.1997 DE 29712960 U
(43) Veröffentlichungstag der Anmeldung: 05.08.1998
(73) Patentinhaber: Strämke, Siegfried, Dr., D-52538 Selfkant (DE)
(72) Erfinder: Strämke, Siegfried, Dr., D-52538 Selfkant (DE)
(74) Vertreter: Selting, Günther, Dipl.-Ing.

(56) Entgegenhaltungen:
- DE-A- 2 900 724
- DE-A- 4 336 919
- PATENT ABSTRACTS OF JAPAN vol. 015, no. 197 (C-0833), 21.Mai 1991 & JP 03 053063 A (DAINIPPON PRINTING CO LTD), 7.März 1991,

## Beschreibung

Die Erfindung betrifft eine Vorrichtung zur Plasma-Oberflächenbehandlung von Werkstücken.

Zur Oberflächenbehandlung, beispielsweise zum Plasmanitrieren, zum Plasmaaufkohlen, zum Plasmakaburieren sowie zum Beschichten von Werkstücken durch das PVD- oder CVD-Verfahren werden an die Werkstückoberfläche hohe Ansprüche gestellt. Wenn die Werkstückoberfläche durch Fremdstoffe verunreinigt, oxidiert oder passiviert ist, muß vor der Plasmabehandlung ein Reinigungsprozeß durchgeführt werden.

Wenn die Werkstücke vor der Plasmabehandlung einer spanenden Bearbeitung unterzogen werden, werden sie im Anschluß an diese Bearbeitung zwischengelagert oder müssen zumindest von der Bearbeitungsvorrichtung zur Vorrichtung für die Oberflächenbehandlung transportiert werden. Hierbei sind die Werkstücke Umgebungseinflüssen ausgesetzt. Beispielsweise oxidieren aufgrund der Luftfeuchtigkeit die bearbeiteten Flächen. Es ist daher vor der Oberflächenbehandlung der Werkstücke unbedingt erforderlich, die Werkstücke zu reinigen.

Bei einem Reinigungsprozeß müssen Fremdstoffe wie Öle und Fette beseitigt werden. Es handelt sich hierbei um äußerst aufwendige Prozesse, da insbesondere bei nichtflüchtigen Verschmutzungen ein Passivieren der Werkstückoberfläche auftreten kann. Beispielsweise ist ein Nitrieren von Werkstücken aus Aluminium äußerst schwierig, da sich bei Kontakt des Aluminiums mit Luft sofort eine Aluminiumoxidschicht bildet, die beim Nitrieren als Diffusionssperre wirkt. Da es sich um eine festhaftende Schicht handelt, ist das Entfernen der Oxidschicht äußerst schwierig.

Aus DE 40 05 956 C1 ist eine Plasma-Behandlungsvorrichtung mit einer evakuierbaren Behandlungskammer bekannt. Um in die Behandlungskammer während des Vakuumbetriebes Werkstücke einbringen und ausbringen zu können, ist der Behandlungskammer eine Schleuse zum Einbringen der Werkstücke vorgeschaltet und eine Schleuse zum Ausbringen der Werkstücke nachgeschaltet. Die Schleuse zum Ausbringen der Werkstücke aus der Behandlungskammer weist zwei seitliche Türen auf, die zu Nachbehandlungskammern führen. Diese Nachbehandlungskammern weisen jeweils eine ins Freie führende Tür auf. Die der Schleuse zum Ausbringen der Werkstücke nachgeschalteten Nachbehandlungskammern dienen zur chemischen oder thermischen Nachbehandlung der zuvor durch eine Plasma-Oberflächenbehandlung behandelten Oberflächen. Auch bei der aus DE 40 05 956 C1 bekannten Vorrichtung ist es erforderlich, die Werkstücke vor dem Einführen in die Behandlungskammer zur Plasma-Oberflächenbehandlung zu reinigen.

In JP-A-03-053063 ist eine Sputtervorrichtung beschrieben, bei der in einer Behandlungskammer zwischen dem zu sputternden Ziel und Basisplatten, auf denen eine Dampfablagerung erfolgen soll, ein Blendenschieber angeordnet ist. An der Rückseite des Blendenschiebers bilden sich Materialablagerungen. Um diese entfernen zu können, ist der Blendenschieber zunächst in eine Ersatzkammer und dann in eine Reinigungskammer hinein verschiebbar. In der Reinigungskammer erfolgt ein Abschleifen der Ablagerungen. Eine mechanische Bearbeitung des Werkstückes erfolgt nicht.

In DE-A-29 00 724 ist eine Vorrichtung zum Beschichten von Substraten im Vakuum beschrieben. Hierbei ist zwischen einer Vorbehandlungskammer und einer Vakuumkammer, die einen Verdampfer enthält, eine Schleuse vorgesehen. Die Werkstücke werden an einer biegsamen Kette durch die Schleuse hindurchgeführt.

Aufgabe der Erfindung ist es, eine Vorrichtung zu schaffen, die eine Plasma-Oberflächenbehandlung von äußerst kontaminierungsempfindlichen Werkstücken ermöglicht.

Die Lösung dieser Aufgabe erfolgt erfindungsgemäß durch die Merkmale des Anspruches 1.

Erfindungsgemäß ist einer Behandlungskammer zur Plasma-Oberflächenbehandlung von Werkstücken einer Bearbeitungskammer vorgeordnet, die eine spanende Bearbeitungsvorrichtung enthält.
Beide Kammern bilden eine gegen die Atmosphäre abgedichtete Einheit, so daß beim Überführen der Werkstücke von der Bearbeitungskammer in die Behandlungskammer keine Umgebungseinflüsse wirksam werden können. In der Bearbeitungskammer können unterschiedliche spanende Bearbeitungswerkzeuge zur Feinbearbeitung, beispielsweise zum Schleifen, Polieren, Honen oder Läppen, vorgesehen sein. Ferner kann in der Bearbeitungskammer auch ein Bearbeitungszentrum mit automatischem Werkzeugwechsel vorgesehen sein. Die Behandlungskammer zur Oberflächenbehandlung der Werkstücke weist zur Plasmaerzeugung erforderliche Energie- und Gaszufuhreinrichtungen sowie Evakuiereinrichtungen auf.

Die beiden in einem Gerät vereinigten Kammern sind gegeneinander und gegenüber der Umgebung gasdicht abgeschlossen. Die Bearbeitungskammer ist von der Behandlungskammer durch eine gasdichte Tür getrennt. Somit kann bei geschlossener Tür ein Werkstück in der Bearbeitungskammer bearbeitet werden. Sind die beiden Kammern durch eine Tür voneinander getrennt, so wird nach der Bearbeitung des Werkstücks der Zustand der Bearbeitungskammer dem Zustand der Behandlungskammer angepaßt. Ist die Behandlungskammer beispielsweise zur Vorbereitung einer Plasmabeschichtung evakuiert, so wird die Bearbeitungskammer ebenfalls evakuiert. Sobald Druckgleichgewicht herrscht, wird die Tür geöffnet, und das Werkstück wird in die Behandlungskammer verschoben. Vorzugsweise ist hierfür zwischen den beiden Kammern eine Transportvorrichtung angeordnet.

Da die Bearbeitungs- und die Behandlungskammer erfindungsgemäß in einer Vorrichtung zusammengefaßt und durch eine gasdichte Tür voneinander getrennt sind, wird das Werkstück nach dem Bearbeiten den Umgebungseinflüssen nicht ausgesetzt. Somit wird die bearbeitete Oberfläche des Werkstückes nicht verunreinigt. Insbesondere treten keine Umgebungsbedingungen auf, aufgrund welcher die Oberfläche oxidiert oder passiviert wird. Dies ist besonders vorteilhaft, wenn die Oberfläche eines Werkstücks behandelt werden soll, das aus einem gegenüber Umgebungseinflüssen empfindlichen Werkstoff besteht. Soll beispielsweise die Oberfläche eines Werkstücks aus Aluminium in der Behandlungskammer nitriert werden, so darf auf der Oberfläche kein Aluminiumoxid vorhanden sein. Die zu nitrierende Oberfläche wird in der Bearbeitungskammer mechanisch bearbeitet und anschließend durch die Tür oder Schleuse direkt in die Behandlungskammer transportiert. Da durch das erfindungsgemäße Verbinden der Bearbeitungskammer mit der Behandlungskammer das Werkstück keinen Umgebungseinflüssen ausgesetzt ist, kann sich auf den zu nitrierenden Flächen keine Aluminiumoxidschicht bilden. Ein aufwendiger Reinigungsprozeß der Werkstücke vor der Oberflächenbehandlung in der Behandlungskammer ist daher nicht erforderlich. Lediglich Bearbeitungsrückstände, wie Späne, werden beispielsweise durch Absaugung entfernt. Dies kann bereits in der Bearbeitungskammer stattfinden.

Die die beiden Kammern trennende Tür kann als Drehtür ausgebildet sein. Es handelt sich hierbei um eine flache Tür, die um eine Mittelachse drehbar ist. Erfindungsgemäß dient die Drehtür zugleich als Werkstückträger. Das zu bearbeitende Werkstück wird direkt auf einer Seite der Drehtür eingespannt. Das Werkstück wird in der Bearbeitungskammer unter einer definierten Atmosphäre bearbeitet. Nach dem Bearbeiten wird der Zustand in den beiden Kammern angeglichen und die Drehtür um die Mittelachse um 180° gedreht. Somit gelangt das soeben bearbeitete Werkstück in die Behandlungskammer und das zuvor in der Behandlungskammer behandelte Werkstück, das auf der gegenüberliegenden Seite der Drehtür aufgespannt ist, wird in die Bearbeitungskammer zurückgedreht. Während der Behandlung des in der Behandlungskammer befindlichen Werkstücks wird das in der Bearbeitungskammer befindliche Werkstück aus dem mit der Drehtür verbundenen Werkstückträger entnommen. Anschließend kann, während die Oberflächenbehandlung in der Behandlungskammer fortgeführt wird, bereits in der Bearbeitungskammer ein weiteres Werkstück auf den Werkstückträger aufgespannt und entsprechend bearbeitet werden. Diese Ausführungsform der Erfindung eignet sich insbesondere für die Einzelbearbeitung und -behandlung von Werkstücken oder für eine geringe Stückzahl zu bearbeitender und behandelnder Werkstücke.

Anstelle einer Drehtür mit zwei gegenüberliegenden Flächen, an welcher die Werkstückträger vorgesehen sind und die jeweils um 180° gedreht wird, kann auch eine zylindrische oder polygone Drehtür vorgesehen sein. Auf jeder der Seitenflächen einer um die Mittelachse drehbaren Drehtür ist ein Werkstückträger vorgesehen. Eine oder mehrere Flächen der Drehtür befinden sich in der Bearbeitungskammer und die übrigen Flächen in der Behandlungskammer. Somit können mehrere Werkstücke gleichzeitig bearbeitet und gleichzeitig behandelt werden.

Um ein Werkstück in definierter Atmosphäre bearbeiten zu können, kann in die Bearbeitungskammer neutrales, oxidierendes oder reduzierendes Gas eingeleitet werden. Ferner ist die Bearbeitungskammer zum Zwecke der Reinigung der Werkstücke mit einer geeigneten Flüssigkeit, beispielsweise Alkohol, befüllbar, so daß die mechanische Bearbeitung der Werkstücke in der Flüssigkeit erfolgen kann.

Das während der Bearbeitung in der Bearbeitungskammer vorhandene Medium wird vorzugsweise zyklisch oder ununterbrochen umgewälzt. Somit wird das Medium von Spänen und Fremdstoffen gereinigt, so daß gleichbleibende Arbeitsbedingungen herrschen. Des weiteren ist sichergestellt, daß keine Späne oder andere Fremdstoffe aus der Bearbeitungskammer beim Öffnen der Tür oder Schleuse in die Behandlungskammer gelangen.

Ferner können zur Optimierung der Bearbeitung und/oder der Behandlung mehrere Kammern vorgesehen sein. Beispielsweise können mehrere Bearbeitungskammern hintereinander angeordnet sein, die jeweils durch gasdichte Türen oder Schleusen voneinander getrennt sind. Somit können mehrere Bearbeitungsschritte beispielsweise in unterschiedlichen Atmosphären nacheinander durchgeführt werden. Im Anschluß an die letzte Bearbeitungskammer ist die Behandlungskammer vorgesehen, die von der letzten Bearbeitungskammer durch eine gasdichte Tür oder Schleuse getrennt ist. Ebenso können auch mehrere Behandlungskammern hintereinander angeordnet sein, die wiederum jeweils durch gasdichte Türen oder Schleusen voneinander getrennt sind, um unterschiedliche Behandlungen eines Werkstückes durchzuführen.

Des weiteren können mehrere Bearbeitungs- und/oder Behandlungskammern nebeneinander angeordnet sein. So ist beispielsweise bei besonderen Bearbeitungs- oder Behandlungsmethoden die Größe der Kammer beschränkt. Bei einer mehrstufigen Behandlung können daher mehrere Werkstücke aus einer größeren Behandlungskammer in mehrere nebeneinander angeordnete kleine Behandlungskammern transportiert werden. Aufgrund des Kombinierens mehrerer Bearbeitungs- und/oder Behandlungskammern kann die Bearbeitung und Behandlung von Werkstücken optimiert werden.

Nachfolgend wird die Erfindung anhand von bevorzugten Ausführungsformen unter Bezugnahme auf die anliegenden Zeichnungen näher erläutert.

Es zeigen:
- Fig. 1: einen schematischen Horizontalschnitt einer ersten bevorzugten Ausführungsform der Erfindung,
- Fig. 2: eine Schnittansicht entlang der Linie II-II in Fig. 1, und
- Fig. 3: eine schematische Draufsicht einer aufgeschnittenen zweiten bevorzugten Ausführungsform.

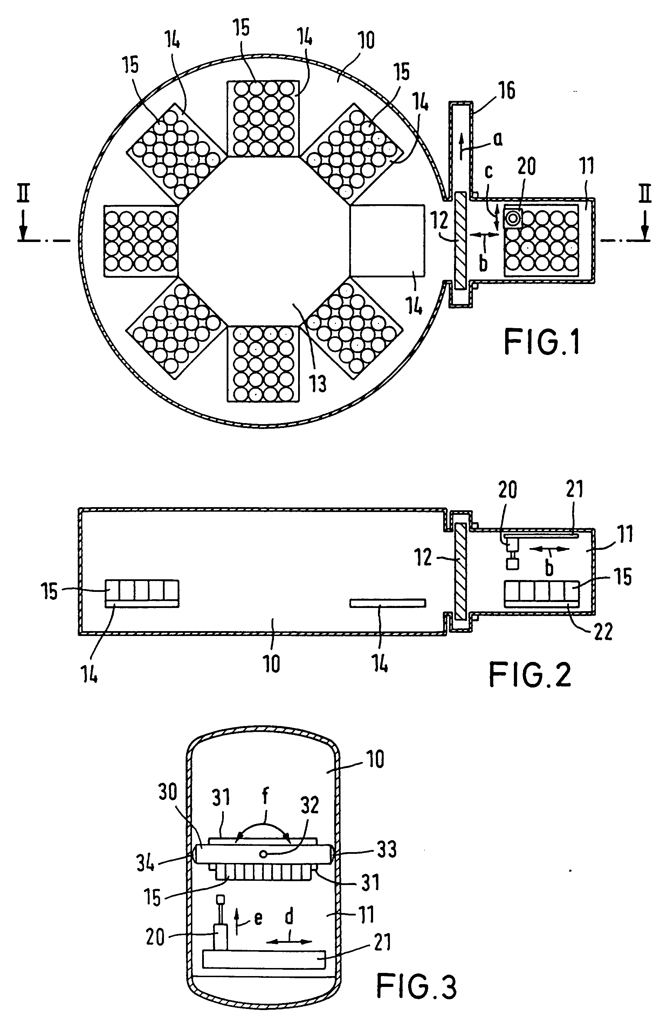

Die in Fig. 1 dargestellte Ausführungsform weist eine Behandlungskammer 10, eine Bearbeitungskammer 11 und eine die beiden Kammern trennende verschiebbare Tür 12 auf. In der Behandlungskammer 10 ist ein Rondell 13 vorgesehen, das am Umfang verteilt mehrere Werkstückträger 14 aufweist. Auf den Werkstückträgern 14 ist jeweils eine Charge Werkstücke 15 angeordnet. Die Werkstückchargen werden durch eine nicht dargestellte verschließbare Öffnung oder durch Abnehmen des Deckels der Behandlungskammer 10 in diese eingebracht.

Die verschiebbare Tür 12 trennt die Behandlungskammer 10 gasdicht von der Bearbeitungskammer 11. Um Werkstücke 15 aus einer der beiden Kammern in die andere Kammer zu verschieben, wird die Tür 12 in Richtung eines Pfeils a in eine Tasche 16 verschoben. Somit sind die beiden Kammern 10,11 miteinander verbunden und die Werkstücke können mittels einer nicht dargestellten Transportvorrichtung von der Bearbeitungskammer 11 in die Behandlungskammer 10 oder umgekehrt verschoben werden.

Wie in der in Fig. 2 dargestellten Schnittansicht gezeigt ist, können die in der Bearbeitungskammer 11 befindlichen Werkstücke 15 von einem Werkzeug 20 bearbeitet werden. Das Werkzeug 20 ist in einer Führung 21 in Richtung eines Pfeils b und eines Pfeils c (Fig. 1) verschiebbar. Die Werkstücke 15 sind in der Bearbeitungskammer 11 auf einem Werkstückträger 22 fixiert. Die Werkstückbearbeitung erfolgt computergesteuert in CNC-Technik.

Die Werkstücke 15 werden in einem ersten Arbeitsschritt in die Behandlungskammer 10 eingebracht. Hierzu werden die Werkstücke 15 in mehreren Chargen durch eine Öffnung oder durch Abnehmen des Deckels auf den Werkstückträgern 14 fixiert. Sobald das Rondell 13 vollständig bestückt ist, wird die Behandlungskammer 10 verschlossen. Die gasdichte Tür 12 wird in die Tasche 16 geschoben, so daß die Behandlungskammer 10 mit der Bearbeitungskammer 11 verbunden ist. Beide Kammern 10,11 bleiben auch bei geöffneter Tür 12 gegenüber der Umgebung gasdicht verschlossen. Mittels einer nicht dargestellten Transportvorrichtung, beispielsweise einem Roboterarm, wird eine erste Werkstückcharge von dem Werkstückträger 14 des Rondells 13, der der Bearbeitungskammer 11 gegenüber angeordnet ist, in die Bearbeitungskammer 11 transportiert. Hier werden die Werkstücke 15 dieser Charge auf einem Werkstückträger 22 in der Bearbeitungskammer 11 fixiert. Anschließend wird die Tür 12 verschoben, so daß die beiden Kammern 10,11 gasdicht voneinander getrennt sind.

Zur mechanischen Bearbeitung der Werkstücke 15 kann die Bearbeitungskammer 11 evakuiert und/oder mit einem Gas oder einer Flüssigkeit gefüllt werden. Während der Bearbeitung der Werkstücke 15 wird das in der Bearbeitungskammer 11 befindliche Medium zyklisch oder ununterbrochen umgewälzt, um eine gleichbleibende Arbeitsatmosphäre aufrechtzuerhalten und Späne auszufiltern.

Sobald sämtliche Werkstücke 15 einer Charge bearbeitet wurden, wird die Bearbeitungskammer 11 evakuiert, um das Bearbeitungsgas aus der Bearbeitungskammer zu entfernen. Sofern in die Behandlungskammer 10 während der Bearbeitung der ersten Werkstückcharge Gas eingeleitet wurde, wird dasselbe Gas in die Bearbeitungskammer 11 eingeleitet, bis zwischen den beiden Kammern 10,11 Druckgleichgewicht herrscht. Wurde die Behandlungskammer 10 während der Bearbeitung der ersten Werkstückcharge lediglich evakuiert, so wird die Bearbeitungskammer 11 evakuiert, bis Druckgleichgewicht zwischen den beiden Kammern 10,11 herrscht. Anschließend wird die Tür 12 in die Tasche 16 geschoben und die Werkstücke 15 werden aus der Bearbeitungskammer 11 mittels der Transporteinrichtung auf den freien Werkstückträger 14, der gegenüber der Bearbeitungskammer 11 angeordnet ist, transportiert. Während des Transports zwischen der Bearbeitungskammer 11 und der Behandlungskammer 10 sind die Werkstücke keinen Umgebungseinflüssen ausgesetzt, so daß die mechanisch bearbeitete Oberfläche der Werkstücke nicht oxidieren kann. Sobald sämtliche Werkstücke 15 der bearbeiteten Charge aus der Bearbeitungskammer 11 in die Behandlungskammer 10 transportiert sind; wird das Rondell 13 um einen Werkstückträger 14 weitergedreht, so daß die nächste Werkstückcharge aus der Behandlungskammer in die Bearbeitungskammer transportiert werden kann. Nun wird die Tür 12 wieder geschlossen und die vorstehend beschriebenen Arbeitsschritte erneut durchgeführt.

Vorstehend beschriebene Arbeitsschritte werden so oft hintereinander durchgeführt, bis sämtliche auf den Werkstückträgern 14 des Rondells 13 befindliche Werkstückchargen in der Bearbeitungskammer 11 bearbeitet wurden. Anschließend werden die Werkstücke 15 in der Behandlungskammer einer Plasma-Oberflächenbehandlung unterzogen. Hierzu ist die Behandlungskammer 10 evakuiert und weist ferner Anschlüsse zur Zufuhr von Behandlungsgasen auf. Ferner sind in der Behandlungskammer 10 Elektrodenanschlüsse für die Plasmabehandlung vorgesehen. Ist die Oberflächenbehandlung der in der Behandlungskammer 10 vorhandenen Werkstücke 15 abgeschlossen, so werden diese wiederum durch die Öffnung der Behandlungskammer 10 oder durch Abnehmen des Deckels aus der Behandlungskammer 10 entnommen.

Anstelle des vorstehend beschriebenen Vorgehens ist es auch möglich, die Werkstücke über die Bearbeitungskammer 11 in die Behandlungskammer 10 einzubringen. Hierzu werden die Werkstücke 15 über eine Öffnung in der Bearbeitungskammer 11 dieser zugeführt und nach dem Bearbeiten wie vorstehend beschrieben in die Behandlungskammer 10 transportiert. Die nächste Charge Werkstücke 15 wird wiederum zuerst der Bearbeitungskammer 11 zugeführt, um dann in die Behandlungskammer 10 transportiert zu werden. Die Behandlungskammer 10 muß somit keine Öffnung und keinen abnehmbaren Deckel aufweisen. Zur Entnahme der Werkstücke 15 aus der Behandlungskammer 10 müssen diese sodann wiederum durch die Bearbeitungskammer 11 entnommen werden.

Die in Fig. 3 dargestellte Vorrichtung zur Bearbeitung und Plasma-Oberflächenbehandlung von Werkstücken weist ebenfalls eine Behandlungskammer 10 und eine Bearbeitungskammer 11 auf. Die beiden Kammern 10,11 sind durch eine Drehtür 30 voneinander getrennt. Die Drehtür 30 weist sowohl auf der der Behandlungskammer 10 als auch auf der der Bearbeitungskammer 11 zugewandten Seite jeweils einen Werkstückträger 31 auf. Die Drehtür 30 ist um eine Mittelachse 32 drehbar. An den Stirnseiten der Drehtür 30 sind Dichtungen 33,34 vorgesehen, die bei geschlossener Drehtür 30 die beiden Kammern 10,11 gegeneinander abdichten, so daß in beiden Kammern 10,11 unterschiedliche Zustände herrschen können. Da die beiden Kammern 10,11 innerhalb einer gemeinsamen Vorrichtung angeordnet sind, die gegenüber der Umgebung gasdicht verschließbar ist, ist das auf dem Werkstückträger 31 aufgespannte Werkstück beim Drehen der Drehtür 30 keinen Umgebungseinflüssen ausgesetzt.

Auf der der Bearbeitungskammer 11 zugewandten Seite der Drehtür 30 sind auf den Werkstückträger 31 Werkstücke 15 einer Werkstückcharge aufgespannt. Zur Bearbeitung der Werkstücke 15 ist ein Werkzeug 20 vorgesehen, das in einer Führung 21 sowohl in Richtung des Pfeils d als auch senkrecht zur Zeichenebene bewegt werden kann. Zur Bearbeitung ist das Werkzeug 20 ferner in Richtung des Pfeils e zu den Werkstücken 15 der Werkstückcharge zustellbar.

Nach der Bearbeitung der Werkstücke 15 wird der Zustand in der Bearbeitungskammer über Evakuierungs- und Gasanschlüsse dem Zustand der Behandlungskammer 10 angeglichen. Anschließend wird die Drehtür 30 um die Mittelachse 32 in Richtung des Pfeils f um 180° gedreht, so daß sich die Werkstücke 15 in der Behandlungskammer 10 befinden. Die Behandlungskammer 10 weist ebenfalls Anschlüsse zum Evakuieren, zur Zufuhr von Behandlungsgasen sowie Elektrodenanschlüsse auf, so daß in der Behandlungskammer eine Plasmabehandlung der Werkstücke 15 durchführbar ist.

Während die Oberfläche der Werkstücke 15 in der Behandlungskammer 10 behandelt wird, kann die Bearbeitungskammer 11 geöffnet werden und ein neues Werkstück auf dem Werkstückträger 31 aufgespannt werden. Befindet sich auf dem Werkstückträger 31 ein zuvor behandeltes Werkstück, so wird dieses von dem Werkstückträger 31 gelöst und aus der Bearbeitungskammer 11 entnommen.

Nach dem Verschließen der Bearbeitungskammer 11 wird das neu aufgespannte Werkstück wiederum mittels des Werkzeugs 20 in einer definierten Atmosphäre bearbeitet. Somit können während des Umspannens und des Bearbeitens von Werkstücken auf der der Bearbeitungskammer 11 zugewandten Seite der Drehtür 30 in der Behandlungskammer 10 Werkstücke 15 behandelt werden, die auf der der Behandlungskammer 10 zugewandten Seite der Drehtür 30 auf einen entsprechenden Werkstückträger 31 aufgespannt sind.

## Patentansprüche

1. Vorrichtung zur Plasma-Oberflächenbehandlung von Werkstücken (15), mit einer evakuierbaren Behandlungskammer (10), die eine Vorrichtung zur Plasmaerzeugung enthält, und einer Bearbeitungskammer (11), die mit der Behandlungskammer durch eine Tür (12,30) verbunden ist und eine spanende Bearbeitungsvorrichtung (20) enthält,
**dadurch gekennzeichnet ,**
dass die Tür (12,30) gasdicht ist und zum Verbinden der Behandlungskammer (10) mit der Bearbeitungskammer (11) in eine Tasche (16) hinein verschiebbar ist oder um eine durch die Türmitte hindurchgehende Achse (32) drehbar ist.

2. Vorrichtung nach Anspruch 1, dadurch gekennzeichnet, daß die Werkstücke (15) mittels einer Transportvorrichtung zwischen beiden Kammern (10,11) verschiebbar sind.

3. Vorrichtung nach Anspruch 1, dadurch gekennzeichnet, daß die die Kammern (10,11) trennende Tür als Drehtür (30) ausgebildet ist, die zugleich einen Werkstückträger bildet.

4. Vorrichtung nach einem der Ansprüche 1-3, dadurch gekennzeichnet, daß zum Öffnen der Tür (12,30) die Bearbeitungskammer (11) vorübergehend evakuierbar ist.

5. Vorrichtung nach einem der Ansprüche 1-4, dadurch gekennzeichnet, daß die Bearbeitungskammer (11) mit einem Gas oder einer Flüssigkeit befüllbar ist.

6. Vorrichtung nach einem der Ansprüche 1-5, dadurch gekennzeichnet, daß das in der Bearbeitungskammer (11) vorhandene Medium zyklisch oder ununterbrochen zur Reinigung von Spänen und Fremdstoffen umgewälzt wird.

7. Vorrichtung nach einem der Ansprüche 1-6, dadurch gekennzeichnet, daß mehrere Bearbeitungskammern (11) und/oder Behandlungskammern (10) vorgesehen sind, die jeweils durch gasdichte Türen miteinander und gegenüber der Umgebung gasdicht verbunden sind.

## Claims

1. An apparatus for the surface treatment of workpieces (15) by means of a plasma, comprising a treatment chamber (10) which can be evacuated and includes means for producing a plasma, and a processing chamber (11) connected to the treatment chamber through a door (12, 30) and including a machining device (20),
characterized in
that the door (12, 30) is gas-tight and, for connecting the treatment chamber (10) with the processing chamber (11), the door may be slid into a pocket (16) or rotated about an axis (32) passing through the center of the door.

2. The apparatus according to claim 1, wherein the workpieces (15) are displaceable between the two chambers (10,11) by means of a transport device.

3. The apparatus according to claim 1, wherein the door separating the chambers (10, 11) is formed as a revolving door forming a workpiece support.

4. The apparatus according to one of claims 1-3, wherein the processing chamber (11) can temporarily be evacuated to open the door (12, 30).

5. The apparatus according to one of claims 1-4, wherein the processing chamber (11) can be filled with a gas or a liquid.

6. The apparatus according to one of claims 1-5, wherein the medium present in the processing chamber (11) circulates cyclically or constantly to cleanse chips and impurities.

7. The apparatus according to one of claims 1-6, wherein multiple processing chambers (11) and/or treatment chambers (10) are provided, each being connected to one another by means of gastight doors or sluices and being sealed against the environment in a gastight manner.

## Revendications

1. Dispositif destiné au traitement de surface par plasma de pièces (15), comportant une chambre de traitement (10) pouvant être mise sous vide contenant un dispositif de génération de plasma, et une chambre d'usinage (11) qui est reliée à la chambre de traitement par une porte (12, 30), et qui contient un dispositif d'usinage (20) par enlèvement de copeaux,
caractérisé en ce que
la porte (12, 30) est étanche aux gaz, et en ce que, pour relier la chambre de traitement (10) à la chambre d'usinage (11), elle peut être déplacée dans une poche (16) ou pivotée autour d'un axe (32) passant par le milieu de la porte.

2. Dispositif selon la revendication 1,
caractérisé en ce que les pièces (15) peuvent être déplacées entre les deux chambres (10, 11) au moyen d'un dispositif de transport.

3. Dispositif selon la revendication 1,
caractérisé en ce que la porte séparant les chambres (10, 11) est réalisée sous la forme d'une porte pivotante (30) qui constitue simultanément un support de pièces.

4. Dispositif selon l'une quelconque des revendications 1 à 3, caractérisé en ce que, pour l'ouverture de la porte (12, 30), la chambre d'usinage (11) peut être temporairement mise sous vide.

5. Dispositif selon l'une quelconque des revendications 1 à 4, caractérisé en ce que la chambre d'usinage (11) peut être remplie par un gaz ou un liquide.

6. Dispositif selon l'une quelconque des revendications 1 à 5, caractérisé en ce que le fluide contenu dans la chambre d'usinage (11) est mis en circulation de façon cyclique ou ininterrompue pour le nettoyage de copeaux et de corps étrangers.

7. Dispositif selon l'une quelconque des revendications 1 à 6, caractérisé en ce qu'il est prévu plusieurs chambres d'usinage (11) et/ou chambres de traitement (10), qui sont respectivement reliées entre elles par des portes étanches aux gaz et de manière étanche aux gaz par rapport à l'environnement.
